# DEMANDE DE BREVET EUROPEEN

(11) **EP 2 221 822 A1**
(43) Date de publication de la demande: **25.08.2010**
(21) Numéro de dépôt: 09305171.2
(22) Date de dépôt: 23.02.2009
(51) Int. Cl.: G11C 7/10

(54) **Procédé de sélection d'une taille de mémoire disponible d'un circuit comprenant au moins un processeur et une mémoire, programme et carte à puces correspondants**

(71) Demandeur: Gemalto SA, 92190 Meudon (FR)
(72) Inventeur: Arnal, Benoît, 92197, MEUDON (FR)
(74) Mandataire: Cassagne, Philippe M.J.

(57) **Abrégé**

L'invention concerne un procédé de sélection d'une taille de mémoire disponible d'un circuit comprenant au moins un CPU et une mémoire totale, le procédé comprenant une étape de sélection d'une taille de mémoire disponible inférieure ou égale à celle de la mémoire totale.

L'invention se **caractérise en ce que** l'étape de sélection est mise en oeuvre par le fabricant d'un produit incorporant ledit circuit, différent du fabricant du circuit, et en ce qu'elle comprend une étape de transmission, via un réseau de communication, à destination d'un équipement, par exemple serveur, accessible par le fabricant du circuit, d'une information représentative de la taille de mémoire disponible ainsi sélectionné par le fabricant du produit.

## Description

La présente invention concerne un procédé de procédé de sélection d'une taille de mémoire disponible d'un circuit comprenant au moins un processeur (par exemple CPU, microprocesseur ou unité de traitement) et une mémoire.

La présente invention va être décrite ici dans le contexte de la fabrication d'un produit particulier, la carte à puce, mais elle peut s'appliquer à d'autres produits incorporant un circuit électronique, par exemple circuit intégré, comprenant un processeur et une mémoire totale. Dans ce même exemple nous parlons de mémoire Non Volatile (NVM) mais l'invention s'applique à tout type de mémoire (NVM, RAM etc...)

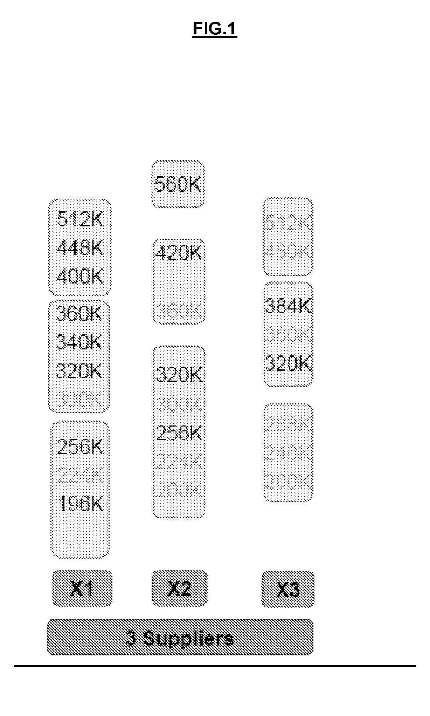

En référence à la Figure 1, selon la technique antérieure, soit trois fournisseurs X1, X2 et X3 de circuits intégrés livrant un fabricant de cartes à puce. Chaque fournisseur dispose de plusieurs références produits. En pratique, cependant, ces différentes références produits disposent d'un même processeur et se distinguent uniquement par des mémoires disponibles respectives différentes. Tel est le cas, à titre d'exemple dans cette Figure 1, pour le fournisseur X1, des produits référencés 300K, 320K, 340K et 360K. Ces produits 300K, 320K, 340K et 360K ont chacun un même processeur mais des tailles de mémoire disponible différentes, respectivement de 300Kbytes, 320Kbytes, 340Kbytes et 360Kbytes.

En réalité même, ces produits ont une même taille mémoire totale de 360Kbytes, mais dans une étape de finale de fabrication/test du circuit, le fabricant de circuit décide de rendre disponible qu'une partie de cette mémoire pour adresser un besoin particulier de ses clients. Dans ce cas, le fabricant de circuit « bloquera » et rendra inaccessible (et n'effectuera par exemple pas de tests pour) la portion de mémoire non rendue disponible et définie dans ce cas particulier par une taille de mémoire égale à la différence entre (a) - les 360Kbytes, et (b) - la taille de mémoire rendue disponible.

Le problème de cette solution selon la technique antérieure est le suivant :
- la sélection par le fabricant de circuit d'une taille de mémoire disponible pour chaque circuit impose au fabricant des circuits la mise en oeuvre d'étapes de personnalisation (différent tests, différentes chaines de production) élaborés dans la fabrication du circuit, rendant plus complexe son élaboration.

L'invention vise à remédier à ces problèmes. A cette fin, un procédé de sélection d'une taille de mémoire disponible d'un circuit comprenant au moins un processeur et une mémoire totale, le procédé comprenant une étape de sélection d'une taille de mémoire disponible inférieure ou égale à celle de la mémoire totale,
est caractérisé selon l'invention en ce que l'étape de sélection est mise en oeuvre par un fabricant d'un produit incorporant ledit circuit, différent du fabricant du circuit, et par
une étape de transmission, via un réseau de communication, à destination d'un équipement, par exemple serveur, accessible par le fabricant du circuit, d'une information représentative de la taille de mémoire disponible ainsi sélectionné par le fabricant du produit.

L'invention présente aussi l'avantage de remédier au décalage important entre les besoins clients tels que perçus par le fournisseur de circuits et la réalité, et facilite ainsi la gestion de stocks pour le fournisseur de circuits, et éventuellement l'acheteur de ces circuits.

Les autres objets de l'invention sont définis par les revendications annexées.

D'autres caractéristiques et avantages de la présente invention apparaîtront plus clairement à la lecture de la description qui suit en relation avec les dessins annexés correspondants dans lesquels :
- La Figure 1, déjà commentée, montre de manière illustrative des circuits produits par trois fournisseurs, les circuits, pour un fournisseur donné, étant groupés dans la figure par identité de processeur ; et
- La Figure 2 illustre sous forme de bloc-diagramme les éléments pour la mise en oeuvre du procédé selon l'invention.

### DESCRIPTION DETAILLEE DE L'INVENTION

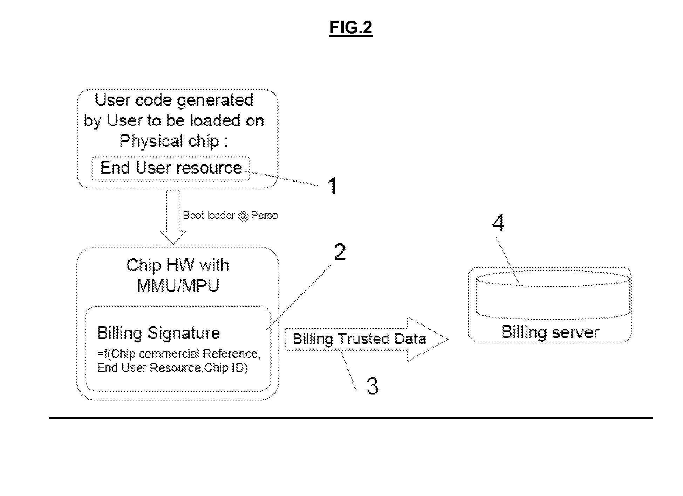

En référence à la Figure 2, selon l'invention, il est proposé d'utiliser un outil de développement fourni par le fournisseur des circuits. Pour revenir à l'exemple de la Figure 1, ce fournisseur livrera à son client, selon l'invention, pour un processeur donné, des circuits non différenciés comprenant un processeur identique et une mémoire totale de 360K (par contraste avec des circuits ayant un même processeur et des tailles de mémoire disponible différentes, respectivement de 300Kbytes, 320Kbytes, 340Kbytes et 360Kbytes, pour une même taille de mémoire totale, selon la technique antérieure).

L'outil de développement livré par le fournisseur des circuits est utilisé par son client, le fabricant de produits, pour sélectionner une taille de mémoire disponible inférieure ou égale à celle de la mémoire totale. En effet, il est proposé que les circuits livrés sont initialement dans un état « bloqué » et que l'outil de développement est requis pour débloquer le circuit par cette sélection de taille de mémoire. Cet outil de développement invite le fabricant de produits à saisir/transmettre vers le circuit non différencié, une information de taille de mémoire disponible désirée. A titre d'exemple, les données suivantes sont alors transmises au circuit :
- Adresse de début, Adresse de Fin, et éventuellement
- Paramètres de configuration d'une unité de gestion de mémoire (MMU) dans le circuit.

Les données « Adresse de début » et « Adresse de Fin » définissent une taille de mémoire disponible sélectionnée du circuit, par exemple 300Kbytes, ou autre, inférieure ou égale à 360Kbytes (taille de la mémoire totale du circuit considéré).

Un « boot loader », également fourni par le fournisseur de circuits, charge ces données dans le circuit pour la configuration de ce dernier. En fonction de ces données, il est procédé notamment au verrouillage, par l'unité de gestion de mémoire du circuit, de l'accessibilité en lecture et/ou écriture à la seule zone de mémoire disponible de la mémoire totale, de taille correspondant à celle sélectionnée. Cette étape de verrouillage, par une unité de gestion de mémoire du circuit, de l'accessibilité en lecture et/ou à une zone de mémoire disponible de la mémoire totale, de taille correspondant à celle sélectionnée, est importante pour assurer au fournisseur du circuit la limitation, à la seule taille de mémoire disponible, de l'usage de la mémoire. Une unité de gestion de mémoire assure la gestion de la mémoire, l'abstraction de l'adressage (conversion d'adresse logique en adresse physique). Cependant, les implémentations spécifiques sont nombreuses. Cette unité de gestion de mémoire est néanmoins adaptée pour inclure une fonctionnalité de refus d'accès en lecture/écriture à toute adresse n'appartenant pas à l'ensemble des adresses de la taille de mémoire disponible définie par le fabricant de produits.

Cette information de paramétrage de la taille de mémoire sélectionnée « Adresse de début, Adresse de Fin » peut optionnellement être stockée de manière inaltérable en clair dans le circuit en mémoire OTP (One Time Programming)

De cette information de paramétrage de la mémoire sélectionnée est également calculé une signature 2 de sécurité en fonction de cette information « Adresse de début, Adresse de Fin » mais également par exemple typiquement d'un numéro de série du circuit, et éventuellement aussi d'un identifiant de référence commerciale du circuit.

L'information comprenant « Adresse de début », « Adresse de Fin », « Numéro de série du circuit » ainsi que la signature associé est ensuite transmise via un réseau de communication, à destination d'un serveur 4, accessible par le fabricant du circuit.

Ainsi, une information représentative de la taille de mémoire disponible ainsi sélectionné par le fabricant du produit est transmise au fournisseur du circuit identifié par son numéro de série, à des fins de facturation notamment. Cette transmission peut être effectuée à tout moment notamment lors de la fabrication du produit. Un accusé de réception par le serveur 4 peut également constituer une condition de déblocage de fonctionnement général du circuit, seules les fonctions élémentaires de reporting au serveur 4 des informations précitées étant autorisée préalablement à cet accusé de réception.

## Revendications

1. Procédé de sélection d'une taille de mémoire disponible d'un circuit comprenant au moins un processeur et une mémoire totale, le procédé comprenant une étape de sélection d'une taille de mémoire disponible inférieure ou égale à celle de la mémoire totale,
**caractérisé en ce que** l'étape de sélection est mise en oeuvre par un fabricant d'un produit incorporant ledit circuit, différent du fabricant du circuit, et par
- une étape de transmission, via un réseau de communication, à destination d'un équipement, par exemple serveur, accessible par le fabricant du circuit, d'une information représentative de la taille de mémoire disponible ainsi sélectionné par le fabricant du produit.

2. Programme d'ordinateur comprenant des instructions exécutables stockées dans une mémoire d'un circuit comprenant un processeur et une mémoire totale, pour la mise en oeuvre d'une méthode, la méthode étant **caractérisée en ce qu'**elle comprend :
- une étape de sélection d'une taille de mémoire disponible inférieure ou égale à celle de la mémoire totale,
- une étape de verrouillage, par une unité de gestion de mémoire du circuit, de l'accessibilité en lecture et/ou écriture à une zone de mémoire disponible de la mémoire totale, de taille correspondant à celle sélectionnée, et
- une étape de transmission via un réseau de communication, à destination d'un serveur, accessible par le fabricant du circuit, d'une information représentative de la taille de mémoire disponible ainsi sélectionné par le fabricant du produit

3. Carte à puce comprenant un programme d'ordinateur tel que revendiqué en revendication 2.
